(19) Europäisches Patentamt
European Patent Office
Office européen des brevets

(11) **EP 3 499 561 B1**

(12) **EUROPEAN PATENT SPECIFICATION**

(45) Date of publication and mention
of the grant of the patent:
**08.05.2024 Bulletin 2024/19**

(21) Application number: **17839499.5**

(22) Date of filing: **08.08.2017**

(51) International Patent Classification (IPC):
*H01L 23/36* (2006.01)    *H05K 7/20* (2006.01)
*H01L 23/373* (2006.01)    *B32B 27/20* (2006.01)
*B32B 7/027* (2019.01)

(52) Cooperative Patent Classification (CPC):
**B32B 7/027; B32B 27/20; H01L 23/3735;
H01L 23/3737; H05K 7/20**

(86) International application number:
**PCT/JP2017/028829**

(87) International publication number:
**WO 2018/030430 (15.02.2018 Gazette 2018/07)**

(54) **HEAT TRANSFER SHEET AND METHOD FOR PRODUCING SAME**

WÄRMEÜBERTRAGUNGSFOLIE UND VERFAHREN ZUR HERSTELLUNG DAVON

FEUILLE DE TRANSFERT DE CHALEUR ET PROCÉDÉ DE PRODUCTION ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.08.2016 JP 2016155519
02.03.2017 JP 2017039164**

(43) Date of publication of application:
**19.06.2019 Bulletin 2019/25**

(73) Proprietor: **Sekisui Chemical Co., Ltd.
Osaka-shi, Osaka 530-8565 (JP)**

(72) Inventors:
• **MUKOHATA, Daisuke**
  **Hasuda-shi, Saitama 349-0198 (JP)**
• **SHIMONISHI, Koji**
  **Hasuda-shi, Saitama 349-0198 (JP)**
• **HAMADA, Masahiro**
  **Hasuda-shi, Saitama 349-0198 (JP)**
• **FUKANO, Keisuke**
  **Hasuda-shi, Saitama 349-0198 (JP)**

(74) Representative: **Ter Meer Steinmeister & Partner
Patentanwälte mbB
Nymphenburger Straße 4
80335 München (DE)**

(56) References cited:
JP-A- H1 177 795       JP-A- 2009 066 817
JP-A- 2009 066 817     JP-A- 2012 038 763
JP-A- 2012 109 313     JP-A- 2012 109 313
JP-A- 2014 027 144     JP-A- 2014 150 161
JP-A- 2015 092 534     US-A1- 2017 038 707
US-B1- 6 794 030

**Description**

Technical Field

The present invention relates to a heat conductive sheet and a method for producing the same.

Background Art

A heat conductive sheet is disposed mainly between a heating element, such as a semiconductor package, and a radiator made of aluminium, copper, or the like and functions to rapidly transfer heat generated in the heating element to the radiator.

Recently, the quantity of heat generated per area of a semiconductor package has become greater due to high integration of a semiconductor element and high densification of wiring in a semiconductor package. Under such circumstances, heat conductive sheets that have an improved heat conductivity to allow the promotion of more rapid heat dissipation than conventional heat conductive sheets are strongly demanded.

Relating to techniques for improving the heat conductivity of a heat conductive sheet, there are disclosed approaches involving orienting a platy heat-conductive filler contained in a heat conductive sheet in the thickness direction of the heat conductive sheet (for example, PTLs 1-5).

In this context PTL 1 and PTL 5 are directed to heat conductive sheets comprising a ceramic material as a heat-conductive filler.

PTL 3 and PTL 4, in contrast, focus on heat conductive sheets with graphite as the heat-conductive filler.

Furthermore, as PTL 6 shows, sheets showing high heat conductivity are not only interesting for the technical filed of semiconductors but also for electrophotography, where they can be applied to a fixing member.

Citation List

Patent Literature

PTL 1: JP 2012-38763 A
PTL 2: JP 2013-254880 A
PTL 3: JP 2012 109313 A
PTL 4: JP 2009 066817 A
PTL 5: US 6 794 030 B1
PTL 6: US 2017/038707 A1

Summary of Invention

Technical Problem

However, the approaches of PTLs 1 and 2 provide a low degree of orientation of the platy heat-conductive filler, and in order to achieve improvement of the heat conductivity, it is unavoidable to use a large amount of the platy heat-conductive filler, which is not preferable in view of flexibility of the heat conductive sheet and the cost of raw materials.

The present invention has been made under these circumstances, and the object of the present invention is to provide a heat conductive sheet that achieves improvement of the heat conductivity thereof with a reduced amount of the platy heat-conductive filler used, and a method for producing the same.

Solution to Problem

As a result of diligent studies, the present inventor has found that a heat conductive sheet having a specific structure can achieve the object above, and thus completed the invention below. The heat conductive sheet according to the present invention has a laminated structure of a plurality of resin layers including a heat-conductive resin layer comprising a platy heat-conductive filler, a sheet major surface being a plane perpendicular to laminated faces of the resin layers, and the major axis of the platy heat-conductive filler being oriented at an angle of 60° or more with respect to the sheet major surface. The heat conductive sheet has an Asker C hardness, as measured according to the method described hereinafter of 70 or less. Furthermore, the resin layers each comprise a liquid resin at 20 °C.

In a preferred embodiment, the width of the heat-conductive resin layer is 1- to 2000-fold larger than the thickness of the platy heat-conductive filler.

Furthermore, the content of the platy heat-conductive filler is preferably 50 to 700 parts by mass per 100 parts by mass of a resin in the heat-conductive resin layer.

In another embodiment, the heat conductive sheet may have a heat conductivity in the thickness direction thereof of 3 W/m·K or more.

Besides that, the heat conductive sheet may have a 30% compressive strength of 1500 kPa or less.

Preferably, all of the resin layers are the heat-conductive resin layers.

Additionally, the heat conductive sheet may comprise as the resin layers the heat-conductive resin layers and non-heat-conductive resin layers free from heat-conductive fillers.

In an embodiment, the non-heat-conductive resin layer is a foamed resin layer comprising a plurality of cells therein.

The heat-conductive resin layer may be a heat-conductive foamed resin layer comprising the platy heat-conductive filler and a plurality of cells therein.

Preferably, the resin layers each are a resin layer using at least one selected from the group consisting of an ethylene/vinyl acetate copolymer, a polyolefin resin, a nitrile rubber, an acrylic rubber, a silicone resin, a diene rubber, and a hydrogenated diene rubber.

The resin in the resin layers may consist of a liquid resin at normal temperature. Furthermore, the platy heat-conductive filler may comprise at least one selected from boron nitride and flaked graphite.

Additionally, a method for producing the above defined heat conductive sheet is provided. The method for producing the heat-conductive resin layer comprises a kneading step of kneading a resin containing a resin that is liquid at 20 °C with a platy heat-conductive filler to prepare a heat-conductive resin composition and a laminating step of laminating the heat-conductive resin composition to prepare a lamination product comprising n layers; and the thickness of the lamination product after the laminating step, D ($\mu$m), and the thickness of the platy heat-conductive filler, d($\mu$m), satisfy the following expression: $0.0005 \leq d/(D/n) \leq 1$.

In a preferred embodiment, the heat-conductive resin composition prepared in the kneading step is divided into $x_i$ portions; the $x_i$ portions are laminated to prepare a lamination product comprising $x_i$ layers; the lamination product is heat-pressed to a thickness of D $\mu$m; and then, dividing, laminating, and heat-pressing are carried out repeatedly to prepare the lamination product comprising n layers.

Further preferred is when an extruder provided with a multilayer forming block is used to obtain lamination product comprising n layers and having a thickness of D $\mu$m through co-extrusion by adjusting the multilayer forming block.

The method according to the present invention may further comprise a step of slicing up the lamination product along a direction parallel to the laminating direction thereof after the laminating step.

Advantageous Effects of Invention

According to the present invention, a heat conductive sheet that achieves improvement of the heat conductivity thereof can be provided while the amount of the platy heat-conductive filler used is reduced.

Brief Description of Drawings

[Fig. 1] Fig. 1 is a schematic cross section of a heat conductive sheet of embodiment 1.
[Fig. 2] Fig. 2 is a schematic cross section of a heat conductive sheet of embodiment 1 when in use.
[Fig. 3] Fig. 3 is a schematic cross section of a heat conductive sheet of embodiment 2.
[Fig. 4] Fig. 4 is a schematic cross section of a heat conductive sheet of a modification example of embodiment 2.

Description of Embodiments

The present invention will now be described in more details by way of embodiments. However, the present invention is not limited to the embodiments described below.

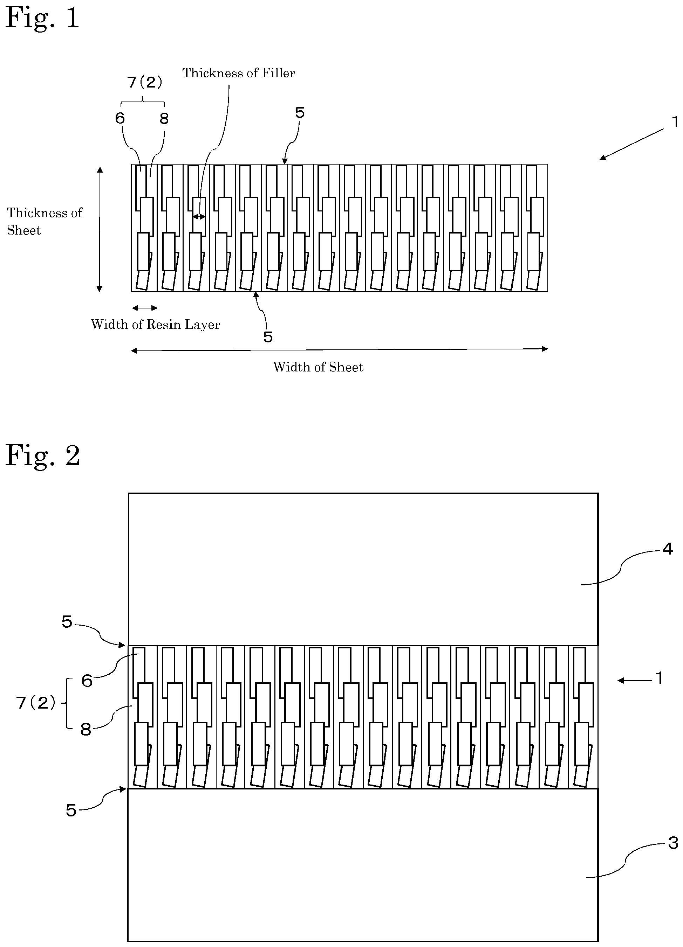

"The thickness of the heat conductive sheet " herein means the length in the vertical direction of the documents of Figs. 1 to 4, and "the width of the heat conductive sheet " and "the width of the resin layer" means the length in horizontal direction of the documents of Figs. 1 to 4. "The thickness of the platy heat-conductive filler" means the length of the shortest side composing the XZ plane or YZ plane when the largest face among faces composing the surface of the platy filler is defined as the XY plane.

(Embodiment 1 of heat conductive sheet)

The present invention is directed to a heat conductive sheet having a laminated structure of a plurality of resin layers including heat-conductive resin layer, a sheet major surface being a plane perpendicular to laminated faces of the resin layers, and the heat-conductive resin layer comprising a platy heat-conductive filler, wherein the major axis of the platy heat-conductive filler is oriented at an angle of 60° or more with respect to the sheet major surface. In view of improving heat conductivity, all of the resin layers are preferably the heat-conductive resin layers. Embodiment 1 illustrates an embodiment wherein all of the resin layers are the heat-conductive resin layers.

Fig. 1 is a schematic cross section of a heat conductive sheet of embodiment 1 in a state in which it is mounted between a heating element 3 and a radiator 4. In fig. 1, hatching for indicating a cross section of the resin is omitted in order to make the presence of the platy heat-conductive filler 6 clear. In figures, each filler particles overlaps upper and lower adjacent filler particles, but the overlapping of filler particles is not necessary in the present invention.

As shown in Fig. 1, the heat conductive sheet 1 has a layered structure comprising resin layers 2. The major sheet surface 5 is a plane perpendicular to the laminated faces of the resin layers 2. As shown in Fig. 2, the heat conductive sheet 1 is disposed such that the major sheet surfaces 5 come into contact with a heating element 3 and a radiator 4, respectively.

The thickness of the heat conductive sheet 1 (in other words, the distance between the major sheet surfaces 5) can be for example, but not particularly limited to, within the range from 0.1 to 30 mm.

In embodiment 1, each of all the resin layers 2 is a heat-conductive resin layer 7 comprising a platy heat-conductive filler 6.

The heat-conductive resin layer 7 is a resin layer 2 having a structure in which the platy heat-conductive filler 6 is dispersed in the resin 8.

The resin 8 is not particularly limited, and various resins can be used therefor, including a polyolefin, a polyamide, a polyester, a polystyrene, a polyvinyl chloride, a polyvinyl acetate, and an ABS resin. At least one selected from the group consisting of an ethylene/vinyl acetate copolymer, a polyolefin resin, a nitrile rubber, an acrylic rubber, a silicone resin, a diene rubber, and a hydrogenated diene rubber is preferably used. The hydrogenated diene rubber is obtained by hydrogenating a diene rubber. Examples of the polyolefin resin include a polyethylene resin and a polypropylene resin. Examples of the nitrile rubber include an acrylonitrile butadiene rubber. Examples of the diene rubber include a polyisoprene rubber, a polybutadiene rubber, and a polychloroprene rubber.

An acrylonitrile butadiene rubber or a polypropylene resin is more preferably used as the resin 8. A polypropylene resin such as a homopolymer of propylene or a copolymer of ethylene and propylene is even more preferably used as the resin 8.

Among these, a copolymer of ethylene and propylene is inexpensive and thermoformable. Therefore, the copolymer of ethylene and propylene can provide the heat conductive sheet 1 with a low cost, and also enables production of the heat conductive sheet 1 with ease.

The resin 8 includes a liquid resin at a normal temperature. The resin 8 may include both of a liquid resin and a solid resin at a normal temperature, but the resin 8 more preferably consists of a liquid resin at a normal temperature. When the resin 8 includes a liquid resin, a load when the resin is kneaded with a platy heat-conductive filler can be decreased in producing the heat conductive sheet 1, and thus, the platy heat-conductive filler is likely to disperse uniformly to improve the heat conductivity. A liquid resin at a normal temperature herein means a resin that is in a liquid state in the conditions of 20°C and 1 atm ($1.01 \times 10^{-1}$ MPa).

As the liquid resin, those in a liquid state among the resin mentioned above can be used, for example, and suitable specific examples thereof include a liquid acrylonitrile butadiene rubber, a liquid ethylene propylene copolymer, a liquid natural rubber, a liquid polyisoprene rubber, a liquid polybutadiene rubber, a liquid hydrogenated polybutadiene rubber, a liquid styrene/butadiene block copolymer, a liquid hydrogenated styrene/butadiene block copolymer, and a liquid silicone resin.

The platy heat-conductive filler 6 is a platy heat-conductive filler having a shape satisfying the relation: longitudinal length of XY plane/thickness>2.0. Examples of the material thereof include a carbide, a nitride, an oxide, a hydroxide, a metal, and a carbon material.

Examples of the carbide include silicon carbide, boron carbide, aluminum carbide, titanium carbide, and tungsten carbide.

Examples of the nitride include silicon nitride, boron nitride, aluminum nitride, gallium nitride, chromium nitride, tungsten nitride, magnesium nitride, molybdenum nitride, and lithium nitride.

Examples of the oxide include iron oxide, silicon oxide (silica), aluminum oxide (alumina) (including hydrates of aluminum oxide (such as boehmite)), magnesium oxide, titanium oxide, cerium oxide, and zirconium oxide. Other examples of the oxide include a transition metal oxide such as barium titanate and also those doped with a metal ion, such as indium tin oxide and antimony tin oxide.

Examples of the hydroxide include aluminum hydroxide, calcium hydroxide, and magnesium hydroxide.

Examples of the metal include copper, gold, nickel, tin, iron, and an alloy thereof.

Examples of the carbon material include carbon black, graphite, diamond, fullerene, carbon nanotube, carbon nanofiber, nanohorn, carbon microcoil, and nanocoil.

These platy heat-conductive fillers 6 can be used singly or in combinations of two or more thereof. The platy heat-conductive filler 6 preferably comprises at least one selected from boron nitride and flaked graphite in view of the heat conductivity. Boron nitride is more preferred particularly for applications for which electric insulation is required.

The platy heat-conductive filler 6 has an average particle size (the length in the longitudinal direction of the XY plane, which is the largest face (hereinafter, simply referred to as "the longitudinal direction")) of, for example, 0.1 to 1000 μm, preferably 0.5 to 500 μm, more preferably 1 to 100 μm, as measured according to a light scattering method.

The thickness of the platy heat-conductive filler 6 is, for example, 0.05 to 500 μm, preferably 0.25 to 250 μm.

As the platy heat-conductive filler 6, a commercially available product or a modified product thereof can be used. Examples of the commercially available product include a commercially available product of a boron nitride particle, and specific examples of the commercially available product of a boron nitride particle include "PT" series (e.g. "PT-110") manufactured by MOMENTIVE PERFORMANCE MATERIALS JAPAN LLC, and "SHOBN UHP" series (e.g. "SHOBN UHP-1") manufactured by SHOWA DENKO K.K.

In the heat-conductive resin layer 7, the major axis of the platy heat-conductive filler 6 in the resin 8 is oriented at an angle of 60° or more with respect to the sheet major surface. If the major axis of the platy heat-conductive filler 6 is oriented at an angle of less than 60° with respect to the sheet major surface, the heat conductive sheet 1 has a low heat conductivity in the thickness direction.

In view of increasing the heat conductivity in the thickness direction of the heat conductive sheet 1, the major axis of the platy heat-conductive filler 6 is preferably oriented at an angle of 70° or more, more preferably 80° or more, even more preferably 80° or more and almost right angle, with respect to the sheet major surface.

The method for measuring the angle is not particularly limited, and the angle may be determined according to the following method: a slice is cut from the longitudinal center portion of the heat-conductive resin layer 7 along the orientation direction of most platy heat-conductive filler 6, which is generally parallel to the flow direction of the resin when molding; the platy heat-conductive filler in the slice is observed under a scanning electron microscope (SEM) at a magnification of 3000; and the angle between the major axis of the platy heat-conductive filler observed and the plane of the sheet major surface of the heat-conductive resin layer 7 is measured. An angle of 60° or more herein means that the average of the found values obtained in the above manner is 60° or more, and does not exclude the presence of the platy heat-conductive filler 6 with an orientation angle of less than 60°. When the angle is more than 90°, the supplementary angle thereof is considered as the found value.

The width of the heat-conductive resin layer 7 is 1- to 2000-fold, preferably 1- to 50-fold, more preferably 1- to 10-fold, even more preferably 1- to 3-fold, most preferably 1- to 2-fold larger than the thickness of the platy heat-conductive filler 6 contained in the heat-conductive resin layer 7. The width of the heat-conductive resin layer 7 within the above described range allow the major axis of the platy heat-conductive filler 6 to orient at an angle of 60° or more with respect to the sheet major surface. The heat-conductive resin layers 7 may not have the same width as long as each width is within the above described range.

As clear from the above, after the width of the heat-conductive resin layer 7 is determined, the number of the resin layers is determined from the relationship "number of resin layers = (width of sheet)/(width of resin layer)".

The content of the platy heat-conductive filler 6 in the heat-conductive resin layer 7 is preferably 50 to 700 parts by mass, more preferably 50 to 500 parts by mass, even more preferably 100 to 400 parts by mass, further more preferably 150 to 300 parts by mass, per 100 parts by mass of the resin 8, and is 15 to 70 vol% based on the total volume of the heat-conductive resin layer.

If the content of the platy heat-conductive filler 6 is less than the above described range, a heat conductive sheet 1 having a heat conductivity in the thickness direction thereof of 3 W/m·K or more cannot be obtained.

On the other hand, use of an excess amount of the platy heat-conductive filler 6 over the above described range is unnecessary for achieving the heat conductivity of this level. As the amount of the platy heat-conductive filler 6 used is larger, the flexibility of the heat conductive sheet is impaired. However, when the amount of the platy heat-conductive filler 6 used is within the above described range, a heat conductive sheet having high heat conductivity can be provided without impairing the flexibility of the heat conductive sheet, i.e. heat conductive sheet having both flexibility and high heat conductivity can be obtained.

Such a good balance between physical properties is probably caused by the orientation of the major axis of the platy heat-conductive filler 6 at an angle of 60° or more with respect to the sheet major surface. The above described good balance between physical properties is also probably caused by the width of the heat-conductive resin layer 7 which is 1- to 2000-fold, preferably 1- to 50-fold, more preferably 1- to 10-fold, even more preferably 1- to 3-fold, most preferably 1-to 2-fold larger than the thickness of the platy heat-conductive filler 6 contained in the heat-conductive resin layer 7.

The heat-conductive resin layer 7 may be a heat-conductive foamed resin layer comprising the platy heat-conductive filler 6 and a plurality of cells therein. When a plurality of cells are contained, the heat conductive sheet 1 has improved flexibility.

(Embodiment 2 of heat conductive sheet)

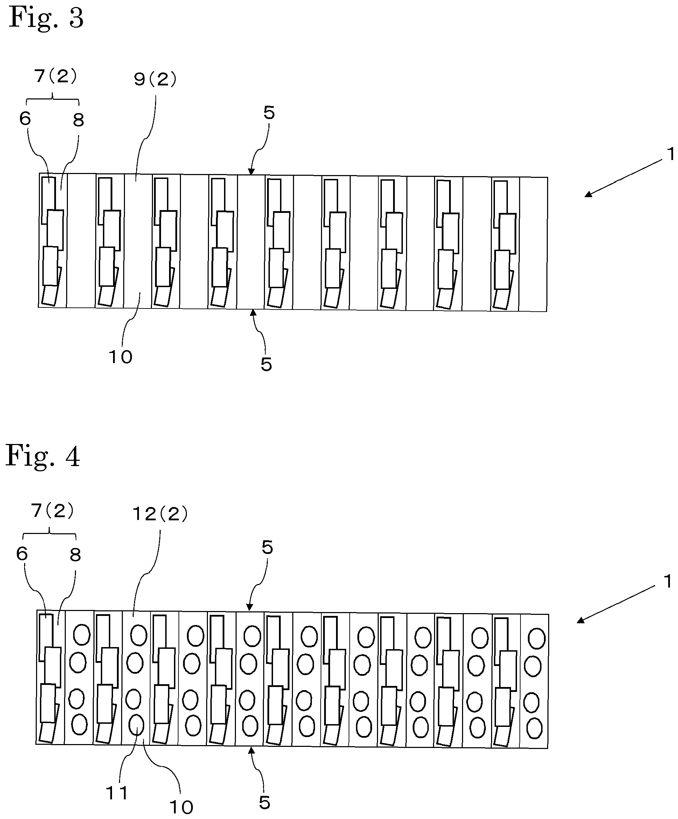

Embodiment 2 illustrates an embodiment of a heat conductive sheet that comprises as the resin layers heat-conductive resin layers comprising a platy heat-conductive filler and non-heat-conductive resin layers free from platy heat-conductive fillers. Fig. 3 is a schematic cross section of a heat conductive sheet of embodiment 2. The heat conductive sheet of embodiment 2 is used in the same state as of embodiment 1 in which the sheet is mounted between a heating element and a radiator, but the mounted state is omitted in the figure.

As shown in Fig. 3, the heat conductive sheet 1 of embodiment 2 has a structure comprising resin layers 2 wherein the heat-conductive resin layers 7 comprising the platy heat-conductive filler 6 and the non-heat-conductive resin layers 9 free from the platy heat-conductive filler 6 are alternately layered.

Although the heat-conductive resin layers 7 and the non-heat-conductive resin layers 9 are alternately laminated in the heat conductive sheet 1 of embodiment 2, these may be laminated at random or may be laminated in a block pattern. When the heat-conductive resin layers 7 and the non-heat-conductive resin layers 9 are alternately laminated, the heat conductive sheet 1 tends to have uniform heat conductivity.

The resin 8 in the heat-conductive resin layers 7 and the resin 10 in the non-heat-conductive resin layers 9 each are not particularly limited, and the various resins described as the resin 8 for embodiment 1 described above can be used. For example, various resins such as a polyolefin, a polyamide, a polyester, a polystyrene, a polyvinyl chloride, a polyvinyl acetate, and an ABS resin can be used. At least one selected from the group consisting of an ethylene/vinyl acetate copolymer, a polyolefin resin, a polyamide, a nitrile rubber, an acrylic rubber, a silicone rubber, a diene rubber, a hydrogenated diene rubber, and an ABS resin is preferably used. As the resin 8 and the resin 10, an acrylonitrile/butadiene rubber, or a polypropylene resin such as a propylene homopolymer and an ethylene/propylene copolymer is more preferably used.

The resin 8 in the heat-conductive resin layers 7 and the resin 10 in the non-heat-conductive resin layers 9 may be the same resin or different resins, but are preferably the same resin in view of enhancing adhesion between the resin layers.

The heat-conductive resin layers 7 each may be a heat-conductive foamed resin layer comprising the platy heat-conductive filler 6 and a plurality of cells therein. When a plurality of cells are contained, the heat conductive sheet 1 has improved flexibility.

As shown in Fig. 4, the non-heat-conductive resin layers 9 each may be a foamed resin layer 12 comprising closed cells 11 therein. When the non-heat-conductive resin layers 9 each is a foamed resin layer 12, the heat conductive sheet 1 has improved flexibility.

(Physical properties of heat conductive sheet)

The heat conductive sheet of the present invention preferably has a heat conductivity in the thickness direction thereof of 3 W/m·K or more, more preferably 5 W/m·K or more, even more preferably 8 W/m·K or more, in view of the good heat dissipation property. The heat conductive sheet generally has a heat conductivity in the thickness direction thereof of 100 W/m·K or less, preferably 70 W/m·K or less. The heat conductivity can be determined according to the method described in Examples.

The heat conductive sheet of the present invention has an Asker C hardness of 70 or less. Preferably, the heat conductive sheet has an Asker C hardness of 50 or less, more preferably 40 or less. The heat conductive sheet has an Asker C hardness of, for example, 1 or more, preferably 5 or more. A heat conductive sheet having such a hardness value has good flexibility. The Asker C hardness can be determined according to the method described in Examples.

The heat conductive sheet of the present invention preferably has a 30% compressive strength of 1500 kPa or less, more preferably 1000 kPa or less, even more preferably 500 kPa or less. The heat conductive sheet has a 30% compressive strength of, for example, 10 kPa or more, preferably 50 kPa or more. A heat conductive sheet having such a compressive strength value has good flexibility. The 30% compressive strength can be determined according to the method described in Examples.

(Method for producing heat conductive sheet)

The heat conductive sheet of the present invention is not particularly limited by the production method thereof, and for example, can be produced according to a method for producing the heat conductive sheet that comprises the kneading step of kneading a resin with a platy heat-conductive filler to prepare a heat-conductive resin composition and the laminating step of laminating the heat-conductive resin composition to prepare a lamination product comprising n layers, wherein the thickness of the lamination product after the laminating step, D ($\mu$m), and the thickness of the platy heat-conductive filler, d ($\mu$m), satisfy the following expression: 0.0005≤d/(D/n)≤1.

An embodiment of the method for producing the heat conductive sheet 1 of the present invention will be described.

Hereinafter, "the thickness of the platy heat-conductive filler (d)" means the length of the shortest side composing the XZ plane or YZ plane when the largest face of the platy filler is defined as the XY plane. "The thickness of the lamination product (D)" means the length of the lamination product in the direction perpendicular to the laminated faces.

In the present embodiment, the heat conductive sheet 1 is obtained according to the method comprising the kneading step and the laminating step described below.

Further, the method can also include the slicing step, if needed.

(Kneading step)

A resin is kneaded with a platy heat-conductive filler to prepare a heat-conductive resin composition.

In the kneading, the resin 8 is preferably kneaded with the platy heat-conductive filler 6 under heating using, for example, a twin screw kneader or a twin screw extruder such as a plasto mill, which can provide a heat-conductive resin composition including the platy heat-conductive filler 6 uniformly dispersed in the resin 8.

(Laminating step)

In the laminating step, the heat-conductive resin composition obtained in the kneading step described above is laminated to prepare a lamination product comprising n layers.

The thickness of the lamination product after the laminating step, D ($\mu$m), and the thickness of the platy heat-conductive filler, d ($\mu$m), satisfy the expression: 0.0005≤d/(D/n)≤1, preferably the expression: 0.02≤d/(D/n)≤1.

As the method for laminating, a method can be used, for example, in which the heat-conductive resin composition prepared in the kneading step is divided into $x_i$ portions; the $x_i$ portions are laminated to prepare a lamination product comprising $x_i$ layers; the lamination product is heat-pressed to a thickness of D $\mu$m; and then, dividing, laminating, and heat-pressing are carried out repeatedly to prepare a lamination product comprising n layers.

According to this method, a lamination product satisfying the following expression can be prepared by dividing and laminating repeatedly:

$$0.0005 \leqq d / (D / \prod_{i=1}^{n} Xi) \leqq 1$$

wherein $x_i$ is a variable, and n≥1.

According to this method, a lamination product preferably satisfying the following expression can be prepared by dividing and laminating repeatedly:

$$0.02 \leqq d / (D / \prod_{i=1}^{n} Xi) \leqq 1$$

wherein $x_i$ is a variable, and n≥1.

According to the technique of reducing the length in the width direction of the heat-conductive resin layer through molding multiple times in such a manner, the molding pressure in each time can be smaller than that in the case where molding is carried out once, and thus phenomenon such as breakage of the laminated structure due to molding can be avoided.

As another method for laminating, a method can be used, for example, in which an extruder provided with a multilayer forming block is used to obtain lamination product comprising n layers and having a thickness of D $\mu$m through co-extrusion by adjusting the multilayer forming block.

Specifically, the heat-conductive resin composition obtained in the kneading step described above is introduced into both of the first extruder and the second extruder, and the heat-conductive resin composition is extruded from the first extruder and the second extruder simultaneously. The heat-conductive resin composition extruded from the first extruder and that from the second extruder are transferred to a feed block. In the feed block, the heat-conductive resin composition extruded from the first extruder and that from the second extruder join to thereby obtain a bilayer product of the heat-conductive resin composition. Then, the bilayer product is transferred to a multilayer forming block, and divided into portions along the planes perpendicular to the laminated faces and parallel to the extrusion direction, and the portions of the lamination product are laminated to prepare a lamination product comprising n layers and having a thickness of D $\mu$m. At this time, the thickness of one layer (D/n) can be adjusted to a desired value by adjusting the multi-layer molded block.

(Slicing step)

If needed, the lamination products obtained in the laminating step are further laminated to a desired thickness and bonded to each other by applying pressure thereto. The product is then sliced up along the direction parallel to the laminating direction to thereby prepare a heat conductive sheet.

Through these steps, a heat conductive sheet having the heat-conductive resin layers with a thickness 1- to 2000-fold larger than the thickness of the platy heat-conductive filler can be obtained in which the major axis of the platy heat-conductive filler is oriented at an angle of 60° or more with respect to the laminated faces of the resin layers.

Examples

The present invention will now be illustrated by way of Examples, but the present invention is not limited thereto.

(Example 1)

85 parts by mass of acrylonitrile butadiene rubber (1) ("N280" manufactured by JSR Corporation; in a liquid state), 15 parts by mass of acrylonitrile butadiene rubber (2) ("N231L" manufactured by JSR Corporation; in a solid state), and 250 parts by mass of boron nitride having a thickness of 1 $\mu$m were melt-kneaded, and the resulting mixture was pressed to obtain a primary sheet having a thickness of 0.5 mm. Then, the laminating step was carried out. Specifically, the sheet of the resin composition obtained was quartered, and the resultant sheets were laminated together to provide a sheet including four layers and having a total thickness of 2 mm. The sheet was pressed again to obtain a secondary sheet having a thickness of 0.5 mm, the thickness of each layer being 0.125 mm. The same process was carried out repeatedly to obtain an n-th order sheet having a thickness of 0.5 mm, the thickness of each layer being 31 $\mu$m. The n-th order sheet was cut into pieces with a length of 25 mm and a width of 25 mm, and 25 pieces thereof were laminated and pressed to bond together. The resultant was arranged in such a direction that the face perpendicular to the laminated faces corresponded to the sheet major surface, thereby obtaining a heat conductive sheet. The heat conductive sheet was evaluated according to the evaluation methods described later, and the results are shown in Table 1.

(Example 2)

92 parts by mass of ethylene/propylene copolymer (1) ("PX-068" manufactured by Mitsui Chemicals, Inc.; in a liquid state), 8 parts by mass of ethylene/propylene copolymer (2) ("JSR EP21" manufactured by JSR Corporation; in a solid state), and 100 parts by mass of flaked graphite having a thickness of 2 $\mu$m (WGNP, manufactured by Bridgestone KBG Co., Ltd.) were melt-kneaded, and the resulting mixture was pressed to obtain a primary sheet having a thickness of 0.5 mm. The sheet of the resin composition obtained was quartered, and the resultant sheets were laminated together to provide a sheet including four layers and having a total thickness of 2 mm. The sheet was pressed again to obtain a secondary sheet having a thickness of 0.5 mm, the thickness of each layer being 0.125 mm. The same process was carried out repeatedly to obtain an n-th order sheet having a thickness of 0.5 mm, the thickness of each layer being 31 $\mu$m. The n-th order sheet was cut into pieces with a length of 25 mm and a width of 25 mm, and 25 pieces thereof were laminated and pressed to bond together. The resultant was arranged in such a direction that the face perpendicular to the laminated faces corresponded to the sheet major surface, thereby obtaining a heat conductive sheet. The heat conductive sheet was evaluated according to the evaluation methods described later, and the results are shown in Table 1.

(Example 3)

85 parts by mass of acrylonitrile butadiene rubber (1) ("N280" manufactured by JSR Corporation; in a liquid state), 15 parts by mass of acrylonitrile butadiene rubber (2) ("N231L" manufactured by JSR Corporation; in a solid state), and 300 parts by mass of boron nitride having a thickness of 1 $\mu$m were melt-kneaded, and the resulting mixture was extruded using a extruder for producing a multi-layered molded block to thereby obtain a multi-layered molded block including 10 layers, each layer having a thickness of 1000 $\mu$m (the width of a heat-conductive resin layer was 1000 $\mu$m). The multi-layered molded block was arranged in such a direction that the face perpendicular to the laminated faces corresponded to the sheet major surface, thereby obtaining a heat conductive sheet. The heat conductive sheet was evaluated according to the evaluation methods described later, and the results are shown in Table 1.

(Example 4)

100 parts by mass of a silicone resin ("KF-96H-100000cs" manufactured by Shin-Etsu Chemical Co., Ltd.; in a liquid state), and 260 parts by mass of boron nitride having a thickness of 1 $\mu$m were melt-kneaded, and the resulting mixture was extruded using a extruder for producing a multi-layered molded block to thereby obtain a multi-layered molded block including 10 layers, each layer having a thickness of 1000 $\mu$m (the width of a heat-conductive resin layer was 1000 $\mu$m). The multi-layered molded block was arranged in such a direction that the face perpendicular to the laminated faces corresponded to the sheet major surface, thereby obtaining a heat conductive sheet. The heat conductive sheet was evaluated according to the evaluation methods described later, and the results are shown in Table 1.

(Example 5)

100 parts by mass of a hydrogenated diene rubber ("L-1203" manufactured by KURARAY CO., LTD.; in a liquid state), and 260 parts by mass of boron nitride having a thickness of 1 $\mu$m were melt-kneaded, and the resulting mixture was extruded using a extruder for producing a multi-layered molded block to thereby obtain a multi-layered molded block including 10 layers, each layer having a thickness of 1000 $\mu$m (the width of a heat-conductive resin layer was 1000 $\mu$m). The multi-layered molded block was arranged in such a direction that the face perpendicular to the laminated faces corresponded to the sheet major surface, thereby obtaining a heat conductive sheet. The heat conductive sheet was evaluated according to the evaluation methods described later, and the results are shown in Table 1.

(Comparative Example 1)

In Comparative example 1, a heat conductive sheet was obtained according to the same method as in Example 1, except that a primary sheet of 3 mm was cut into pieces with a length of 25 mm and a width of 25 mm and that 25 pieces thereof were laminated but were not pressed.
Specifically, 85 parts by mass of acrylonitrile butadiene rubber (1) ("N280" manufactured by JSR Corporation; in a liquid state), 15 parts by mass of acrylonitrile butadiene rubber (2) ("N231L" manufactured by JSR Corporation; in a solid state), and 250 parts by mass of boron nitride having a thickness of 1 $\mu$m were melt-kneaded, and the resulting mixture was pressed to obtain a primary sheet having a thickness of 3 mm. Then, the primary sheet was cut into pieces with a length of 25 mm and a width of 25 mm, and 25 pieces thereof were laminated and bonded together by heating without pressing. The resultant was arranged in such a direction that the face perpendicular to the laminated faces corresponded to the sheet major surface, thereby obtaining a heat conductive sheet. The heat conductive sheet was evaluated according to the evaluation methods described later, and the results are shown in Table 1.

(Comparative Example 2)

In Comparative example 2, a heat conductive sheet was obtained according to the same method as in Example 2, except that a primary sheet of 4.2 mm was cut into pieces with a length of 25 mm and a width of 25 mm and that 25 pieces thereof were laminated but were not pressed.
Specifically, 92 parts by mass of ethylene/propylene copolymer (1) ("PX-068" manufactured by Mitsui Chemicals, Inc.; in a liquid state), 8 parts by mass of ethylene/propylene copolymer (2) ("JSR EP21" manufactured by JSR Corporation; in a solid state), and 100 parts by mass of flaked graphite having a thickness of 2 $\mu$m (WGNP, manufactured by Bridgestone KBG Co., Ltd.) were melt-kneaded, and the resulting mixture was pressed to obtain a primary sheet having a thickness of 4.2 mm. Then, the primary sheet was cut into pieces with a length of 25 mm and a width of 25 mm, and 25 pieces thereof were laminated and bonded together by heating without pressing. The resultant was arranged in such a direction that the face perpendicular to the laminated faces corresponded to the sheet major surface, thereby obtaining a heat conductive sheet. The heat conductive sheet was evaluated according to the evaluation methods described later, and the results are shown in Table 1.

(Evaluation)

(1) Measurement of orientation angle of filler

The cross section of the heat conductive sheet was observed under a scanning electron microscope (S-4700 manufactured by Hitachi, Ltd.). In an observation image at a magnification of 3000, the angle between the major axis of the filler and the sheet major surface was measured for arbitrary 20 particles of the filler, and the average was taken as the orientation angle. The result is shown in Table 1.

(2) Measurement of heat conductivity

The heat conductive sheet 25 mm square was sandwiched between a ceramic heater and a water-cooling radiator plate, and heated. After 20 minutes, the temperature of the ceramic heater, T1, and the temperature of the water-cooling radiator plate, T2, were measured. These found values; the applied power to the ceramic heater, W; the thickness of the heat conductive sheet, t; and the area of the heat conductive sheet, S, were substituted into the equation below to calculate the heat conductivity λ. The result is shown in Table 1.

$$\lambda = t \times W / \{S \times (T1 - T2)\}$$

(3) Asker C hardness

The heat conductive sheets 25 mm square were laminated to a thickness of 10 mm or more, and the Asker C hardness was measured thereon with an Asker rubber durometer type C (manufactured by KOBUNSHI KEIKI CO., LTD.) at 23°C. The result is shown in Table 1.

(4) 30% compressive strength

The compressive strength of the heat conductive sheet obtained was measured using "RTG-1250" manufactured by A&D Company, Limited. The size of the sample was adjusted to 2 mm × 15 mm × 15 mm, and the measurement was carried out at a measurement temperature of 23°C and a compression rate of 1mm/min.

Table 1

| | | | Example 1 | Example 2 | Example 3 | Example 4 | Example 5 | Comparative Example 1 | Comparative Example 2 |
|---|---|---|---|---|---|---|---|---|---|
| Raw materials of heat-conductive resin layer (parts by mass) | Resin | Acrylonitrile butadiene rubber (1) | 85 | | 85 | | | 85 | |
| | | Acrylonitrile butadiene rubber (2) | 15 | | 15 | | | 15 | |
| | | Ethylene/propylene copolymer (PX-068) | | 92 | | | | | 92 |
| | | Ethylene/propylene copolymer (EP21) | | 8 | | | | | 8 |
| | | Silicone resin | | | | 100 | | | |
| | | hydrogenated butadiene rubber | | | | | 100 | | |
| | Filler | Boron nitride (Thickness 1 μm) | 250 | | 300 | 260 | 260 | 250 | |
| | | Flaked graphite (Thickness 2 μm) | | 100 | | | | | 100 |
| Heat conductive sheet | | Width of heat-conductive resin layer (μm) | 31 | 31 | 1000 | 1000 | 1000 | 3000 | 4200 |
| | | Thickness of filler (μm) | 1 | 2 | 1 | 1 | 1 | 1 | 2 |
| | | Width of heat-conductive resin layer/ Thickness of filler | 31 | 15.5 | 1000 | 1000 | 1000 | 3000 | 2100 |
| | | Orientation angle of filler (°) | 83.3 | 83.9 | 83.5 | 83.2 | 84.1 | 58.4 | 59.3 |
| | | Heat conductivity in thickness direction of sheet (W/m·K) | 9.1 | 14.8 | 10.1 | 8.1 | 8.5 | 6 | 7 |
| | | Asker C hardness | 68 | 47 | 68 | 37 | 31 | 65 | 44 |
| | | 30% compressive strength | 780 | 781 | 793 | 281 | 261 | 760 | 769 |
| | | Presence of foamed resin layer | no | no | no | no | no | no | no |

It was found that the heat conductivity λ of the heat conductive sheet of Example 1 and that of Example 3 were larger than the heat conductivity λ of the film of Comparative Example 1. It was found that the heat conductivity λ of the heat conductive sheet of Example 2 was larger than the heat conductivity λ of the film of Comparative Example 2.

The effect of the present invention is achieving coexistence of heat conductivity and flexibility, which means "a lower hardness when compared on the same heat conductivity level".

It was found that the heat conductive sheets of Examples each had a low Asker C hardness and a low 30% compressive strength, and thus had a good flexibility.

[Heat conductive sheet having foamed resin layers]

(Example 6)

85 parts by mass of acrylonitrile butadiene rubber (1) ("N280" manufactured by JSR Corporation; in a liquid state), 15 parts by mass of acrylonitrile butadiene rubber (2) ("N231L" manufactured by JSR Corporation; in a solid state), and 300 parts by mass of boron nitride having a thickness of 1 μm were melt-kneaded, and the resulting mixture was pressed to obtain a primary sheet having a thickness of 0.5 mm. The sheet obtained was equally divided into 16 pieces to prepare 16 pieces of a heat-conductive resin layer having a thickness of 0.5 mm. Then, a foam sheet of 0.5 mm obtained according to the method described below was equally divided into 16 pieces to prepare 16 pieces of a foamed resin layer having a thickness of 0.5 mm. The pieces of the heat-conductive resin layer and the pieces of the foamed resin layer were alternately laminated and bonded together, and the resultant was arranged in such a direction that the face perpendicular to the laminated faces corresponded to the sheet major surface, thereby obtaining a heat conductive sheet composed of the foamed resin layers and the heat-conductive resin layers. An adhesive (6004N, manufactured by 3M Company) was used for bonding. The heat conductive sheet was evaluated according to the evaluation methods described above, and the results are shown in Table 2.

(Preparation of foam sheet)

100 parts by mass of acrylonitrile butadiene rubber (2) ("N231L" manufactured by JSR Corporation; in a solid state), 5 parts by mass of azodicarbonamide, and 0.1 parts by mass of a phenol antioxidant were melt-kneaded, and the resulting mixture was pressed to obtain a foamable resin sheet having a thickness of 0.15 mm. The both sides of the foamable resin sheet were irradiated with 1.5 Mrad of an electron ray at 500 keV of an acceleration voltage to crosslink the foamable resin sheet. Then, the resulting foamable resin sheet was heated to 250°C to foam, thereby obtaining a foam sheet having an apparent density of 0.25g/cm$^3$ and a thickness of 0.5 mm.

Table 2

| | | | Example 6 |
|---|---|---|---|
| Raw material of heat-conductive resin layer (parts by mass) | Resin | Acrylonitrile butadiene rubber (1) | 85 |
| | | Acrylonitrile butadiene rubber (2) | 15 |
| | | Ethylene/propylene copolymer (1) | |
| | | Ethylene/propylene copolymer (2) | |
| | | Silicone resin | |
| | | hydrogenated butadiene rubber | |
| | Filler | Boron nitride (Thickness 1 μm) | 300 |
| | | Flaked graphite (Thickness 2 μm) | |
| Raw material of foamed resin layer (parts by mass) | Resin | Acrylonitrile butadiene rubber (2) | 100 |
| | Foaming agent | Azodicarbonamide | 5 |
| | Antioxidant | Phenol antioxidant | 0.1 |

(continued)

|  | | Example 6 |
|---|---|---|
| Heat conductive sheet | Width of heat-conductive resin layer ($\mu$m) | 500 |
| | Thickness of filler ($\mu$m) | 1 |
| | Width of heat-conductive resin layer/ Thickness of filler | 500 |
| | Orientation angle of filler (°) | 78.2 |
| | Width of foamed resin layer ($\mu$m) | 500 |
| | Heat conductivity in thickness direction of sheet (W/m·K) | 5.6 |
| | Asker C hardness | 45 |
| | 30% compressive strength | 351 |
| | Presence of foamed resin layer | yes |

It can be seen from the results in Example 6 that a heat conductive sheet having foamed resin layers has a low Asker C hardness and a low 30% compressive strength, and thus is excellent in flexibility.

The heat conductive sheet according to Example 6 has a lamination product including heat-conductive layers and foamed resin layers that are laminated alternately, and therefore, the content in vol% of the heat-conductive filler in the heat conductive sheet is about 60% relative to that in Comparative Example 1 in Table 1. However, the heat conductive sheet according to Example 6 almost equals the film according to Comparative Example 1 in the heat conductivity, and has much lower Asker C hardness and 30% compressive strength than the film according to Comparative Example 1, which reveals that the heat conductive sheet according to Example 6 has excellent flexibility.

Reference Signs List

1 Heat conductive sheet
2 Resin layer
3 Heating element
4 Radiator
5 Sheet major surface
6 Platy heat-conductive filler
7 Heat-conductive resin layer
8 Resin
9 Non-heat-conductive resin layer
10 Resin
11 Closed cell
12 Foamed resin layer

## Claims

1.  A heat conductive sheet (1) having a laminated structure of a plurality of resin layers (2) including a heat-conductive resin layer comprising a platy heat-conductive filler (6), a sheet major surface (5) being a plane perpendicular to laminated faces of the resin layers (2), and the major axis of the platy heat-conductive filler (6) being oriented at an angle of 60° or more with respect to the sheet major surface, (5) wherein the heat conductive sheet (1) has an Asker C hardness, of 70 or less, as measured thereon with an Asker rubber durometer type C (manufactured by KOBUNSHI KEIKI CO., LTD.) at 23°C, and **characterized in that** the resin layers (2) each comprise a resin that is liquid at 20 °C.

2.  The heat conductive sheet (1) according to claim 1, wherein the width of the heat-conductive resin layer (2) is 1- to 2000-fold larger than the thickness of the platy heat-conductive filler (6).

3. The heat conductive sheet (1) according to claim 1 or 2, wherein the content of the platy heat-conductive filler (6) is 50 to 700 parts by mass per 100 parts by mass of a resin in the heat-conductive resin layer (2).

4. The heat conductive sheet (1) according to any one of claims 1 to 3, wherein the heat conductive sheet (1) has a heat conductivity in the thickness direction thereof of 3 W/m·K or more.

5. The heat conductive sheet (1) according to any one of claims 1 to 4, wherein the heat conductive sheet (1) has a 30% compressive strength of 1500 kPa or less.

6. The heat conductive sheet (1) according to any one of claims 1 to 5, wherein all of the resin layers (2) are the heat-conductive resin layers.

7. The heat conductive sheet (1) according to any one of claims 1 to 5, wherein the heat conductive sheet (1) comprises as the resin layers (2) the heat-conductive resin layers and non-heat-conductive resin layers (9) free from heat-conductive fillers (6).

8. The heat conductive sheet (1) according to claim 7, wherein the non-heat-conductive resin layer : (9) is a foamed resin layer comprising a plurality of cells (11) therein.

9. The heat conductive sheet (1) according to any one of claims 1 to 8, wherein the heat-conductive resin layer (2) is a heat-conductive foamed resin layer comprising the platy heat-conductive filler (6) and a plurality of cells (11) therein.

10. The heat conductive sheet (1) according to any one of claims 1 to 9, wherein the resin layers (2) each are a resin layer using at least one selected from the group consisting of an ethylene/vinyl acetate copolymer, a polyolefin resin, a nitrile rubber, an acrylic rubber, a silicone resin, a diene rubber, and a hydrogenated diene rubber.

11. The heat conductive sheet (1) according to any one of claims 1 to 10, wherein the resin in the resin layers (2) consists of a liquid resin at normal temperature.

12. The heat conductive sheet (1) according to any one of claims 1 to 11, wherein the platy heat-conductive filler (6) comprises at least one selected from boron nitride and flaked graphite.

13. A method for producing the heat conductive sheet (1) according to any one of claims 1 to 12, wherein a method for producing the heat-conductive resin layer (2) comprises the kneading step of kneading a resin containing a resin that is liquid at 20 °C with a platy heat-conductive filler (6) to prepare a heat-conductive resin composition and the laminating step of laminating the heat-conductive resin composition to prepare a lamination product comprising n layers; and the thickness of the lamination product after the laminating step, D ($\mu$m), and the thickness of the platy heat-conductive filler (6), d($\mu$m), satisfy the following expression:

$$0.0005 \leq d/(D/n) \leq 1.$$

14. The method according to claim 13, wherein the heat-conductive resin composition prepared in the kneading step is divided into $x_i$ portions; the $x_i$ portions are laminated to prepare a lamination product comprising $x_i$ layers; the lamination product is heat-pressed to a thickness of D $\mu$m; and then, dividing, laminating, and heat-pressing are carried out repeatedly to prepare the lamination product comprising n layers.

15. The method according to claim 13, wherein an extruder provided with a multilayer forming block is used to obtain lamination product comprising n layers and having a thickness of D $\mu$m through co-extrusion by adjusting the multilayer forming block.

16. The method according to any one of claims 13 to 15, comprising the step of slicing up the lamination product along a direction parallel to the laminating direction thereof after the laminating step.

**Patentansprüche**

1. Wärmeleitende Folie (1) mit einer laminierten Struktur aus einer Vielzahl von Harzschichten (2), einschließlich einer wärmeleitenden Harzschicht, die einen plattenförmigen wärmeleitenden Füllstoff (6) umfasst, wobei eine Hauptoberfläche der Folie (5) eine Ebene senkrecht zu den laminierten Flächen der Harzschichten (2) ist, und die Hauptachse des plattenförmigen wärmeleitenden Füllstoffs (6) in einem Winkel von 60° oder mehr in Bezug auf die Hauptoberfläche der Folie (5) ausgerichtet ist, wobei die wärmeleitende Folie (1) eine Asker C-Härte von 70 oder weniger aufweist, gemessen mit einem Asker-Gummi-Durometer Typ C (hergestellt von KOBUNSHI KEIKI CO., LTD.) bei 23°C, und

**dadurch gekennzeichnet, dass** die Harzschichten (2) jeweils ein Harz umfassen, das bei 20°C flüssig ist.

2. Wärmeleitende Folie (1) nach Anspruch 1, wobei die Breite der wärmeleitenden Harzschicht (2) 1- bis 2000-mal größer ist als die Dicke des plattenförmigen wärmeleitenden Füllstoffs (6).

3. Wärmeleitende Folie (1) nach Anspruch 1 oder 2, wobei der Gehalt des plattenförmigen wärmeleitenden Füllstoffs (6) 50 bis 700 Massenteile pro 100 Massenteile eines Harzes in der wärmeleitenden Harzschicht (2) beträgt.

4. Wärmeleitende Folie (1) nach einem der Ansprüche 1 bis 3, wobei die wärmeleitende Folie (1) in ihrer Dickenrichtung eine Wärmeleitfähigkeit von 3 W/m·K oder mehr aufweist.

5. Wärmeleitende Folie (1) nach einem der Ansprüche 1 bis 4, wobei die wärmeleitende Folie (1) eine 30%-Druckfestigkeit von 1500 kPa oder weniger aufweist.

6. Wärmeleitende Folie (1) nach einem der Ansprüche 1 bis 5, wobei alle Harzschichten (2) die wärmeleitenden Harzschichten sind.

7. Wärmeleitende Folie (1) nach einem der Ansprüche 1 bis 5, wobei die wärmeleitende Folie (1) als Harzschichten (2) die wärmeleitenden Harzschichten und nicht wärmeleitende Harzschichten (9), die frei von wärmeleitenden Füllstoffen (6) sind, umfasst.

8. Wärmeleitende Folie (1) nach Anspruch 7, wobei die nicht wärmeleitende Harzschicht (9) eine geschäumte Harzschicht mit einer Vielzahl von Zellen (11) darin ist.

9. Wärmeleitende Folie (1) nach einem der Ansprüche 1 bis 8, wobei die wärmeleitende Harzschicht (2) eine wärmeleitende geschäumte Harzschicht ist, die den plattenförmigen wärmeleitenden Füllstoff (6) und eine Vielzahl von Zellen (11) darin umfasst.

10. Wärmeleitende Folie (1) nach einem der Ansprüche 1 bis 9, wobei die Harzschichten (2) jeweils eine Harzschicht sind, die mindestens eines, ausgewählt aus der Gruppe bestehend aus einem Ethylen/Vinylacetat-Copolymer, einem Polyolefinharz, einem Nitrilkautschuk, einem Acrylkautschuk, einem Silikonharz, einem Dienkautschuk und einem hydrierten Dienkautschuk, verwendet.

11. Wärmeleitende Folie (1) nach einem der Ansprüche 1 bis 10, wobei das Harz in den Harzschichten (2) aus einem bei Normaltemperatur flüssigen Harz besteht.

12. Wärmeleitende Folie (1) nach einem der Ansprüche 1 bis 11, wobei der plattenförmige wärmeleitende Füllstoff (6) mindestens eines, ausgewählt aus Bornitrid und Flockengraphit, umfasst.

13. Verfahren zur Herstellung der wärmeleitenden Folie (1) nach einem der Ansprüche 1 bis 12, wobei ein Verfahren zur Herstellung der wärmeleitenden Harzschicht (2) den Knetschritt des Knetens eines Harzes, das ein Harz enthält, das bei 20°C flüssig ist, mit einem plattenförmigen wärmeleitenden Füllstoff (6) zur Herstellung einer wärmeleitenden Harzzusammensetzung und den Laminierschritt des Laminierens der wärmeleitenden Harzzusammensetzung zur Herstellung eines Laminierprodukts, umfassend n Schichten, umfasst; und die Dicke des Laminierprodukts nach dem Laminierschritt, D ($\mu$m), und die Dicke des plattenförmigen wärmeleitenden Füllstoffs (6), d($\mu$m), den folgenden Ausdruck erfüllen:

$$0{,}0005 \leq d/(D/n) \leq 1.$$

14. Verfahren nach Anspruch 13, wobei die im Knetschritt hergestellte wärmeleitende Harzzusammensetzung in $x_i$ Portionen geteilt wird, die $x_i$ Portionen laminiert werden, um ein Laminierprodukt herzustellen, das $x_i$ Schichten

umfasst, das Laminierprodukt auf eine Dicke von D μm wärmegepresst wird, und dann das Teilen, Laminieren und Wärmepressen wiederholt durchgeführt werden, um das Laminierprodukt, das n Schichten umfasst, herzustellen.

15. Verfahren nach Anspruch 13, wobei ein Extruder, der mit einem Mehrschichtformungsblock versehen ist, verwendet wird, um ein Laminierprodukt, das n Schichten umfasst und eine Dicke von D μm aufweist, durch Coextrusion zu erhalten, indem der Mehrschichtformungsblock eingestellt wird.

16. Verfahren nach einem der Ansprüche 13 bis 15, umfassend den Schritt des Aufschneidens des Laminierprodukts entlang einer Richtung parallel zu seiner Laminierrichtung nach dem Laminierschritt.

**Revendications**

1. Feuille thermoconductrice (1) ayant une structure stratifiée constituée d'une pluralité de couches de résine (2) incluant une couche de résine thermoconductrice comportant une charge thermoconductrice lamellaire (6), une grande surface de feuille (5) étant un plan perpendiculaire à des faces stratifiées des couches de résine (2), et le grand axe de la charge thermoconductrice lamellaire (6) étant orienté à un angle de 60 ° ou plus par rapport à la grande surface de feuille (5),

   dans laquelle la feuille thermoconductrice (1) a une dureté Asker C de 70 ou moins, lorsque mesurée sur celle-ci avec un duromètre Asker de type C pour caoutchouc (fabriqué par KOBUNSHI KEIKI CO., LTD.) à 23 °C, et **caractérisée en ce que** les couches de résine (2) comportent chacune une résine qui est liquide à 20 °C.

2. Feuille thermoconductrice (1) selon la revendication 1, dans laquelle la largeur de la couche de résine thermoconductrice (2) est de 1 à 2 000 fois plus grande que l'épaisseur de la charge thermoconductrice lamellaire (6).

3. Feuille thermoconductrice (1) selon la revendication 1 ou 2, dans laquelle la teneur en charge thermiquement conductrice lamellaire (6) est de 50 à 700 parties en masse pour 100 parties en masse d'une résine dans la couche de résine thermoconductrice (2).

4. Feuille thermoconductrice (1) selon l'une quelconque des revendications 1 à 3, dans laquelle la feuille thermoconductrice (1) a une conductivité thermique dans une direction d'épaisseur de celle-ci de 3 W/m·K ou plus.

5. Feuille thermoconductrice (1) selon l'une quelconque des revendications 1 à 4, dans laquelle la feuille thermoconductrice (1) a une résistance à la compression à 30 % de 1 500 kPa ou moins.

6. Feuille thermoconductrice (1) selon l'une quelconque des revendications 1 à (5), dans laquelle toutes les couches de résine (2) sont les couches de résine thermoconductrice.

7. Feuille thermoconductrice (1) selon l'une quelconque des revendications 1 à 5, dans laquelle la feuille thermoconductrice (1) comporte en tant que couches de résine (2) les couches de résine thermoconductrice et des couches de résine non thermoconductrice (9) exemptes de charges thermoconductrices (6).

8. Feuille thermoconductrice (1) selon la revendication 7, dans laquelle la couche de résine non thermoconductrice (9) est une couche de résine expansée comportant une pluralité de cellules (11) dans celle-ci.

9. Feuille thermoconductrice (1) selon l'une quelconque des revendications 1 à 8, dans laquelle la couche de résine thermoconductrice (2) est une couche de résine expansée thermoconductrice comportant la charge thermoconductrice lamellaire (6) et une pluralité de cellules (11) dans celle-ci.

10. Feuille thermoconductrice (1) selon l'une quelconque des revendications 1 à 9, dans laquelle les couches de résine (2) sont chacune une couche de résine utilisant au moins un élément choisi parmi le groupe constitué d'un copolymère d'éthylène/acétate de vinyle, d'une résine de polyoléfine, d'un caoutchouc nitrile, d'un caoutchouc acrylique, d'une résine de silicone, d'un caoutchouc diénique et d'un caoutchouc diénique hydrogéné.

11. Feuille thermoconductrice (1) selon l'une quelconque des revendications 1 à 10, dans lequel la résine dans les couches de résine (2) est constituée d'une résine liquide à température normale.

**12.** Feuille thermoconductrice (1) selon l'une quelconque des revendications 1 à 11, dans laquelle la charge thermoconductrice lamellaire (6) comporte au moins un élément choisi parmi du nitrure de bore et du graphite en flocons.

**13.** Procédé pour produire la feuille thermoconductrice (1) selon l'une quelconque des revendications 1 à 12, dans lequel un procédé pour produire la couche de résine thermoconductrice (2) comporte l'étape de malaxage consistant à malaxer une résine contenant une résine qui est liquide à 20 °C avec une charge thermoconductrice lamellaire (6) pour préparer une composition de résine thermoconductrice, et l'étape de stratification consistant à stratifier la composition de résine thermoconductrice pour préparer un produit de stratification comportant n couches ; et l'épaisseur du produit de stratification après l'étape de stratification D ($\mu$m, et l'épaisseur de la charge thermo-conductrice lamellaire (6), d($\mu$m), satisfont à l'expression suivante : $0{,}0005 \leq d/(D/n) \leq 1$.

**14.** Procédé selon la revendication 13, dans lequel la composition de résine thermoconductrice préparée à l'étape de malaxage est divisée en $x_i$ portions ; les $x_i$ portions sont stratifiées pour préparer un produit de stratification comportant $x_i$ couches ; le produit de stratification est pressé thermiquement jusqu'à une épaisseur de D $\mu$m ; et une division, une stratification et une pression thermique sont ensuite réalisées de manière répétée pour préparer le produit de stratification comportant n couches.

**15.** Procédé selon la revendication 13, dans lequel une extrudeuse pourvue d'un bloc de formage multicouche est utilisée pour obtenir un produit de stratification comportant n couches et ayant une épaisseur de D $\mu$m par co-extrusion en réglant le bloc de formage multicouche.

**16.** Procédé selon l'une quelconque des revendications 13 à 15, comportant l'étape consistant à couper le produit de stratification en tranches le long d'une direction parallèle à la direction de stratification de celui-ci après l'étape de stratification.

## Fig. 1

## Fig. 2

Fig. 3

Fig. 4

**EP 3 499 561 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012038763 A
- JP 2013254880 A
- JP 2012109313 A

- JP 2009066817 A
- US 6794030 B1
- US 2017038707 A1